Europäisches Patentamt

**European Patent Office**

**Office européen des brevets**

(19)

(11) Publication number: **0 181 968**
A1

# EUROPEAN PATENT APPLICATION

(12)

(21) Application number: **84201672.7**

(22) Date of filing: **20.11.84**

(51) Int. Cl.⁴: **G 03 F 7/06,** G 03 C 5/36, G 03 C 5/26 // G03F3/10, G03F1/00

(43) Date of publication of application: **28.05.86 Bulletin 86/22**

(71) Applicant: **AGFA-GEVAERT naamloze vennootschap, Septestraat 27, B-2510 Mortsel (BE)**

(84) Designated Contracting States: **AT BE CH DE FR GB IT LI LU NL SE**

(72) Inventor: **Laridon, Urbain Leopold, Damhertenlaan 36, B-2610 Wilrijk (BE)**

(54) **Process for the production of photographic relief images by tanning development and wash-off processing of silver halide emulsion materials.**

(57) A process for preparing a photographic resist image which comprises the steps of:

(1) exposing to a subject a photographic material comprising:

(i) a support,

(ii) a transparent or translucent substantially non-hardened hydrophilic colloid layer essentially containing gelatin as binder and incorporating a hardening developing agent,

(iii) a substantially non-hardened hydrophilic colloid layer essentially containing gelatin as binder and incorporating colouring substances,

(iv) a substantially non-hardened gelatin silver halide emulsion layer, and

(v) a transparent substantially non-hardened gelatin top layer, and

(2) contacting the exposed material with an alkaline aqueous liquid to activate the development of the developable silver halide,

(3) removing the substantially unhardened portions by wash-off, wherein said liquid contains at least 100 g potassium carbonate per liter to reduce the swelling of the resist and to improve its resistance against abrasion.

- 1 -

## Process for the production of photographic relief images by tanning development and wash-off processing of silver halide emulsion materials

The present invention relates to a process for the production of photographic relief images by tanning development and wash-off processing of silver halide emulsion materials.

Tanning development of photosensitive gelatino-silver halide emulsion materials has been found wide application in the production of relief images on tracing cloth or any other support. The silver halide emulsion layer or a layer adjacent thereto normally contains pigment particles that serve as imaging substance optionally in conjunction with the silver formed in the development. The process has been used succesfully in making reproductions of drawings, maps, colour proofs and line and screen copies. For drafting purposes the pigment particles are normally black and the silver is not removed by bleaching from the resist portions obtained in the tanning development and wash-off processing. The silver halide emulsion layer may be of the negative or direct-positive type and the photographic material contains preferably already in the exposure stage the hardening developing agent so that the hardening development is carried out in an aqueous alkaline activator liquid. The hardening developing agent is e.g. pyrogallol, pyrocatechine, hydroquinone or derivatives thereof as described, e.g. in GB-P 812,673, 1,072,862, 1,097,608, 1,294,355 and in US-P 3,364,024, 4,233,392 and 4,427,757.

As disclosed in the periodical Image Technology - Dec./Jan. (1973), p. 20-24 an increasing pH of the alkaline activator liquid results in an increase of the development rate and a reduction of the emulsion swell such being in favour of the mechanical strength of the resist image.

In said periodical tests have been described running with different types of activator, viz. hydroxide, carbonate and borate having respectively pH values of 12.9, 11.5 and 11. It was determined that the highest wash-off density (in the resist area) was obtained with the hydroxide. Therefore the conclusion was drawn that improved physical characteristics should be expected with the highest-pH activator, i.e. here with the hydroxide.

With the advent of rapid-access machine processing wherein guiding and driving rollers make contact with the resist image fully tanned, poorly swollen relief patterns with good adhesion to their support are a demand to prevent damage to the image especially where the image contains GV 1345 tiny half-tone screen dots and/or fine lines.

A wash-off film element particularly suited for half-tone screen and line reproductions is a photographic composite layer material containing in the following order :

(i)    a support, e.g. a hydrophobic resin film support provided with (a) subbing layer(s) for a hydrophilic colloid layer,

(ii)   a transparent or translucent substantially non-hardened gelatin layer containing a hardening developing agent,

(iii)  a substantially non-hardened gelatin binder layer being coloured with a diffusion resistant dye or pigment,

(iv)   a substantially non-hardened gelatin silver halide emulsion layer, and

(v)    a transparent substantially non-hardened gelatin protective top layer.

The absence of colouring or opacifying matter from the silver halide emulsion layer makes it possible to expose it without loss in photosensitivity.  The colouring matter in layer (iii) serves as imaging substance and plays also more or less the role of anti-halation dye improving the image sharpness.

The transparent or translucent gelatin layer (ii) serves as a barrier layer between the support and the coloured layer (iii), to prevent the colouring substances from directly contacting the support from which it can only be removed difficultly in the wash-off processing when it stands in direct contact therewith.  Such is particularly the case when the support has a micro-relief structure as is present in drafting or tracing film to improve the writability.

The above defined wash-off processable photographic material having definitely desirable qualities by its high photosensitivity and very low background fog, requires owing to the presence of the several layers containing gelatin a very intensive hardening and a reduction of swelling as much as possible to withstand the mechanical handling in machine processing and the pressure exerted by a warm water spray applied in the wash-off processing stage.

It is an object of the present invention to provide a process for the production of relief images by tanning development and wash-off processing of a photographic composite layer material as defined above resulting in relief images having a better resistance against abrasion GV 1345 and wash-off treatment.

Other objects and advantages of the present invention will become clear from the further description.

In accordance with the present invention a process for preparing a photographic resist image is provided, which process comprises the steps of :

(1) exposing to a subject a photographic material comprising in the following order :

    (i)    a support optionally provided with (a) subbing layer(s) for improving the adherence thereto of a hydrophilic colloid layer,

    (ii)    a transparent or translucent substantially non-hardened hydrophilic colloid layer essentially containing gelatin as binder and incorporating a hardening developing agent,

    (iii)  a substantially non-hardened hydrophilic colloid layer essentially containing gelatin as binder and incorporating colouring substances, e.g. a diffusion resistant dye or pigment,

    (iv)   a substantially non-hardened gelatin silver halide emulsion layer, and

    (v)   a transparent substantially non-hardened gelatin protective top layer,

(2) contacting the exposed material with an alkaline aqueous liquid to activate the development of the developable silver halide forming image-wise oxidized developing agent acting as tanning agent for gelatin, and

(3) removing the substantially unhardened portions of the layers (ii) to (v) by wash-off,

characterized in that said alkaline aqueous liquid contains at least 110 g of potassium carbonate per liter, e.g. contains the potassium carbonate in a concentration of 110 to 150 g per liter.

By the term "substantially non-hardened gelatin" as used herein is meant gelatin that is capable of being melted or dissolved in water at a temperature between 26 and 71 °C, preferably between 32 and 44 °C.

In addition to gelatin as binding agent other hardenable hydrophilic colloids may be used, e.g. polyvinyl alcohol and a polyacrylamide.

The colouring substances elected for use according to the present invention have to be chemically inert in the processing and washing liquid(s) as much as possible and have to be diffusion-resistant in GV 1345

gelatin. Pigment dyes that are applied from an aqueous dispersion are used preferably, though the use of substantive dyes that are chemically linked to a colloid or polymer is not excluded.

It has been found experimentally that pigments, which are insoluble or very poorly soluble in water and in organic liquids of the alcohol or polyhydric alcohol type, e.g. glycerol, fulfil the requirements of resistance to diffusion.

Apart from the use of dyes, the absorption spectrum of which has to satisfy particular requirements for colour-proofing, all colours are considered e.g. cyan, light-cyan, magenta, warm magenta, black, yellow, green, brown, orange, red, white or blue as well as metallic colours such as pale gold, rich gold, copper, and silver. In other words the term "colour" in the present invention encompasses all pure and mixed colours as well as black and white.

When being used in colour proofing they have to match with the absorption spectrum of the standard process inks as close as possible. Particulars about standard colour inks can be found in H.M.Cartwright - Ilford Graphic Arts Manual (1962) VoL. I - pages 502 to 504.

There exist "cold" and "warm" colour standards. Cold colour tones are, e.g. standardized in the U.S.A. in the GATF-Colour Charts and in the German Standards DIN 16508 and 16509. Warm colour tones are standardized, e.g. in the German Standard DIN 16538.

Diffusion-resistant pigments suitable for use in the present invention are known organic pigments, e.g. obtainable under the Trade Marks "PIGMOSOL" and "COLANYL" dyes. "PIGMOSOL" and "COLANYL" are organic pigments that are mixed with a dispersing agent for an aqueous medium. These pigments excel in resistance to light, heat, acids, bases, oxidizing agents, and solvents. They are insoluble in hydrophilic colloids such as gelatin.

The concentration of the pigment in layer (iii) is preferably high enough to reach an optical density at their peak absorption of at least 0.1 and e.g. up to 2.0.

The pigment for obtaining a black-toned image is preferably carbon black, e.g. having an average particle size of 0.5 $\mu$m.

In order to obtain images with a good resolution, relatively thin coloured colloid coatings are preferred. Preferably they have a thickness in the range of 0.5 $\mu$m and 10 $\mu$m. Good results are obtained

with coloured colloid layers containing 0.1 to 5 g of gelatin per sq.m.
Very good results are obtained with coloured layers having a thickness of
2 to 4 μm and containing 0.5 to 2 g of gelatin per sq.m. The hydrophilic
colloid layers contain preferably at least 50 % by weight of gelatin.

The transparent or translucent layer (ii) has preferably a thickness
in the range of 0.5 to 5 μm. Preferably the gelatin coverage of layer
(ii) is in the range of 0.6 to 1.5 g per $m^2$.

The silver halide emulsion layer (iv) has preferably a silver halide
coverage equivalent to from 0.3 to 3.5 g of silver nitrate per $m^2$. The
gelatin to silver nitrate weight ratio is preferably in the range of 0.5
to 3.0.

The gelatin coverage of the toplayer (v) is preferably in the range
of 0.5 to 1.5 g per $m^2$.

The top layer may contain a small amount of translucent pigments,
e.g. silica particles, protruding from the layer and being a few microns
thicker than the top layer. They avoid sticking of rolled up sheet
material at relatively high (e.g. 60 %) relative humidity.

The hardening developing agent such as hydroquinone is preferably
present in layer (ii) in an amount of 50 mg to 1 g per $m^2$.

In the toplayer (v) there is preferably applied an auxiliary
developing agent. Useful auxiliary developing agents include
3-pyrazolidinone developing agents, e.g. 1-phenyl-3-pyrazolidinone and
1-phenyl-4,4'-dimethyl-3-pyrazolidinone. These auxiliary developing
agents are preferably present in an amount ranging from 10 mg to 200 mg
per $m^2$.

According to a modified embodiment the hardening developing agent
and/or auxiliary developing agent is (are) present in the silver halide
emulsion layer (iv).

The support may be rigid as well as flexible and only must present by
itself or by means of (a) subbing layer(s) a good adherence in wet as
well as in dry state to the composite layer structure.

Depending on the use of the wash-off print the support is transparent
or opaque. So, it is possible to use metal layers or sheets, glass,
ceramics, resin supports and paper impermeabilized for the processing and
wasning liquids.

For purposes such as colour-proofing and drafting film it is
preferred to use a resin support with high dimensional stability.
GV 1345

Resin supports characterized by a high mechanical strength and very low water-absorption and consequently high dimensional stability in dry and wet state can be formed from a linear polyester, e.g. polyethylene terephthalate.

Good results as to dimensional stability are obtained with aluminium sheets sandwiched between two high wet-strength paper sheets although this material is rather expensive.

The resin supports can be made opaque by coating them with a matted subbing layer or by matting or colouring them in the mass. The matting may be effected by pigments known therefor in the art, e.g. titanium dioxide, zinc oxide, and barium sulphate. Matting can also be obtained by producing a "blushcoat" as described e.g. in United Kingdom Patent Specification 943,681.

Hydrophobic resin supports for use according to the present invention are coated with one or more subbing layers for a hydrophilic colloid layer.

Preferred subbing layers for use on a hydrophobic resin support, e.g. a polyethylene terephthalate support, are described e.g. in the United Kingdom Patent Specification 1,234,755.

For application as drafting or tracing film the support has a roughened surface to improve the writability and transscribability with pencils, indian ink, felt pen, etc. Suitable tracing film supports are described, e.g. in GB-P 1,121,859, 1,242,046, and in US-P 2,964,423, 3,353,958, 3,370,951, 3,533,795, 3,589,905, 3,666,532 and 4,399,179.

In the silver halide emulsion layer for use according to the present invention the silver halide may comprise silver chloride, silver bromide, silver bromoiodide, silver chlorobromoiodide and the like, or mixtures thereof. The emulsions may be coarse- or fine-grain and can be prepared by any of the well-known procedures, e.g., single-jet emulsions, double-jet emulsions, such as Lippmann emulsions, ammoniacal emulsions, thiocyanate- or thioether-ripened emulsions such as those described in U.S. Patent Specifications 2,222,264 of Adolph H. Nietz and Frederick J. Russell, issued November 19, 1940, 3,320,069 of Bernard D. Illingsworth, issued May 16, 1967, and 3,271,157 of Clarence E. McBride, issued September 6, 1966. Surface-image emulsions may be used or internal-image emulsions may be used such as those described in U.S. Patent Specifications 2,592,250 of Edward Philip Davey and Edward Bowes Knott, GV 1345 issued April 8, 1952, 3,206,313 of Henry D. Porter, Thomas H. James and Wesley G. Lowe, issued September 14, 1965, and 3,447,927 of Robert E. Bacon and Jean F.Barbier, issued June 3, 1969. The emulsions may be regular-grain emulsions such as the type described by Klein and Moisar in J. Photogr. Sci., Vol. 12, No. 5, Sept./Oct. 1964, pp. 242-251. If desired, mixtures of surface- and internal-image emulsions may be used as described in U.S. Patent Specification 2,996,382 of George W. Luckey and John C. Hoppe, issued August 15, 1961.

Apart from negative-working silver halide emulsions that are preferred for their high light sensitivity, direct-positive silver halide emulsions may be used that produce a positive silver image and a corresponding image-wise distribution of developing agent oxidation products during their development. For example those direct positive silver halide emulsions are considered wherein by exposure or by a chemical treatment a developable fog has been produced, which is destroyed image-wise during the image-wise exposure when certain conditions are fulfilled. In the unexposed areas the fog is maintained so that during the subsequent development a direct-positive silver image is obtained and in correspondence therewith an image-wise distribution of oxidized hardening developing agent.

For example, direct positive emulsions of the type described in P.J.Hillson, U.S. Patent 3,062,651, may be utilized to obtain direct positive images. In emulsions of this type, a non-hardening fogging agent such as stannous chloride, formamidine sulfinic acid, or the like is used.

More details about composition, preparation and coating of silver halide emulsions are described, e.g., in Product Licensing Index, Vol. 92, December 1971, publication 9232, p. 107-109.

The emulsions can be chemically sensitized, e.g. by adding sulphur-containing compounds, e.g. allyl isothiocyanate, allyl thiourea, sodium thiosulphate and the like, during the chemical ripening stage. Also reducing agents, e.g. the tin compounds described in the Belgian Patent Specifications 493,464 filed January 24, 1950 and 568,687 filed June 18, 1958, both by Gevaert Photo-Producten N.V., and polyamines such as diethylenetriamine or derivatives of aminomethane-sulphonic acid, e.g. according to the Belgian Patent Specification 547,323 filed April 26, 1956 by Gevaert Photo-Producten N.V., can be used as chemical GV 1345

sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

Further it is possible to sensitize the emulsions with polyalkylene oxide derivatives, e.g. with polyethylene oxide having a molecular weight between 1000 and 20,000, or with condensation products of alkylene oxides and aliphatic alcohols, glycols, cyclic dehydration products of hexitols, alkyl-substituted phenols, aliphatic carboxylic acids, aliphatic amines, aliphatic diamines and amides. The condensation products have a molecular weight of at least 700, preferably of more than 1000. For obtaining special effects these sensitizers of course can be combined with each other as described in Belgian Patent Specification 537,278 filed April 12, 1955 and UK Patent Specification 727,982 filed February 5, 1952, both by Gevaert Photo-Producten N.V.

The emulsions can also be spectrally sensitized, e.g. by the usual mono- or polymethine dyes such as acidic or basic cyanines, hemicyanines, oxonols, hemioxonols, styryl dyes or others, also tri- or polynuclear methine dyes, e.g. rhodacyanines or neocyanines. Such sensitizers are described, e.g., by F.M.HAMER in "The Cyanine Dyes and Related Compounds" (1964) Interscience Publishers, John Wiley & Sons, New York.

The emulsions may contain the usual stabilizers such as, e.g., homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxyl or amino groups. Compounds of this kind are described by BIRR in Z. Wiss. Photogr. Photophys. Photochem. 47,, 2-27 (1952). Still other suitable sensitizers are amount others heterocyclic mercapto compounds, e.g. phenylmercaptotetrazole, quaternary benzothiazole derivatives, benzotriazole and the like.

Particularly useful hardening developing agents, also called tanning developing agents for effecting the development of the silver halide and capable of producing oxidized developing agent acting as hardening agent for a hydrophilic colloid binder containing reactive hydrogen atoms such as gelatin are for example : 1,4-dihydroxy benzene compounds such as

hydroquinone, chlorohydroquinone, bromohydroquinone, toluhydroquinone, morpholinemethyl hydroquinone, sulfohydroquinone and the like.

By the fact that the developing agent is incorporated in the photographic material itself the development can be attained by using an alkaline activator liquid.

The activator bath used according to the present invention has preferably a pH of at least 13 and contains as already mentioned at least 110 g of potassium carbonate, optionally in admixture with an alkali metal hydroxide such as potassium hydroxide in an amount lower than 30 g per liter, a wetting agent, a calcium complexing agent and a silver image toning agent or anti-fogging agent.

According to a preferred embodiment the activator processing is carried out at a temperature in the range of 16 to 25 °C and proceeds within a period of e.g. 10 to 20 s.

The activator liquid may contain a substance yielding sulphite ions, preferably sodium sulphite, acting as an anti-oxidizing agent but more specifically controlling the hardening degree of the gelatin by its reaction with the quinone hardening agent formed in the development step. The higher the concentration of sulphite the easier the erasability with a wet rubber eraser of colloid relief image portions obtained on a support such as a tracing film base. A practically useful concentration of sodium sulphite is in the range of 0.5 to 5 g/l of activator liquid.

After the hardening development step the non-hardened portions of the composite layer are preferably washed off without mechanical rubbing by means of a water spray at a temperature preferably between 30 and 50°C at a pressure of 0.5 to 3.5 kg/cm$^2$. Excess of liquid is preferably removed by squeezing the processed material having a relief image between two smooth soft rollers, e.g. rubber rollers.

The production of a halftone wash-off print is illustrated in more details in the following comparative example.

Example

A. The preparation of the photographic tracing material.

Onto a double matte polyester drawing film were coated in the following order :

(1) a gelatin layer containing 1 g of gelatin and 0.5 g of hydroquinone per m$^2$.

GV 1345

0181958

- 10 -

(2) a gelatin layer containing 0.8 g of gelatin and 0.15 g of carbon black pigment per $m^2$, whereby an optical density of 0.6 was obtained.

(3) a light-sensitive silver chloride-bromide emulsion (2 mole % bromide) having a silver halide content corresponding with 2.5 g of silver nitrate per $m^2$ and a gelatin coverage of 1.5 g per $m^2$.

(4) a top layer containing 0.5 g of gelatin per $m^2$ and 0.1 g of 1-phenyl-4-methyl-3-pyrazolidinone per $m^2$.

B. The exposure.

The exposure of the photographic material proceeded in contact through a halftone wedge having a % dot value varying from 5 to 95 % and a ruling varying from of 65 to 110 lines per cm.

C. The activator processing.

The activator processing proceeded at 20 °C for 15 s in a shallow tray processor handling the material to be developed with hard rubber transport and conveyer rollers and containing in different tests alkaline aqueous liquids having the composition as described in the following table.

D. The wash-off processing.

The wash-off processing proceeded in a COPYLINE Combi 126 wash-off processing machine with a water spray at a temperature of 40 °C sprayed at a pressure of 3 kg/$cm^2$ onto the activator-developed material. COPYLINE is a registered trade name of Agfa-Gevaert N.V. Belgium.

TABLE

| Test No. | 1 | 2 | 3 | 4 | 5 | 6 | 7 | 8 |
|---|---|---|---|---|---|---|---|---|
| demineralized water | 600ml | 600ml | 600ml | 600ml | 600ml | 600ml | 600ml | 600ml |
| KOH | 22.5g | 32.5g | 22.5g | 22.5g | 22.5g | - | 22.5g | 56g |
| $Na_2CO_3$ | - | - | - | - | - | - | 70g | - |
| $K_2CO_3$ | 9g | 45g | 90g | 110g | 150g | 150g | - | - |
| KBr | 0.5g | 0.5g | 0.5g | 0.5g | 0.5g | 0.5g | 0.5g | 0.5g |
| benzotriazole | 0.025g | 0.025g | 0.025g | 0.025g | 0.025g | 0.025g | 0.025g | 0.025g |
| 1-phenyl-5-mercaptotetrazole | 0.005g | 0.005g | 0.005g | 0.005g | 0.005g | 0.005g | 0.005g | 0.005g |
| GV 1345 | | | | | | | | |

0181968

- 11 -

| demineralised water up to | 1000ml | 1000ml | 1000ml | 1000ml | 1000ml | 1000ml | 1000ml | 1000ml |
|---|---|---|---|---|---|---|---|---|
| pH 22°C | 13.56 | 13.68 | 13.69 | 13.80 | 13.82 | 12.15 | 13.50 | 14 |
| swell factor value | 6.25 | 5.50 | 4.75 | 3.80 | 2.37 | 2.20 | 4.30 | 7 |

In test 1 was established that 9 g of $K_2CO_3$ per liter of activator liquid resulted in a strong smudging with carbon black of the activator liquid in the roller processing machine and that reduction of optical density in the relief portions (wash-off portions) was too high in the wash-off stage.

In test 2 was established that with 45 g of $K_2CO_3$ the smudging proceeded less fast but that reduction of optical density in the relief portions was too high in the wash-off stage.

In test 3 operating with 90 g per liter of $K_2CO_3$ was established that the smudging of the activator bath had stopped but reduction of optical density in the obtained relief portions (wash-off density) was still too high in the wash-off stage.

In test 4 operating with 110 g per liter of $K_2CO_3$ was established that the reduction of optical density in the obtained relief portions (wash-off density) in the wash-off stage was practically nil.

In test 5 operating with 150 g per liter of $K_2CO_3$ and 22.5 g of potassium hydroxide in the activator liquid was established that the reduction of optical density in the obtained relief portions (wash-off density) in the wash-off stage was nil.

In test 6 operating with 150 g per liter of $K_2CO_3$ and none of potassium hydroxide in the activator liquid was established that the reduction of optical density in the obtained relief portions (wash-off density) in the wash-off stage was also nil and swelling of the relief portions was still lower than with the presence of the potassium hydroxide.

In test 7 operating with 70 g per liter of $Na_2CO_3$ (at the limit of its dissolvability) in the activator liquid was established that a considerable reduction of optical density in the obtained relief portions GV 1345

(wash-off density) took place and that swelling of the relief portions was higher than in tests 4 to 6.

In test 8 operating with 56 g of KOH (pH = 14) in the activator liquid was established that smudging of the activator liquid took place and the fine relief portions were damaged and removed in the wash-off step.

The indicated swell values obtained with the different activator liquids in the different tests are inversially proportional to the mechanical strenght of the obtained relief image portions.

The swell factor value was determined as the ratio of the sum of $S_1 + S_2$ divided by $S_1$, wherein $S_1$ is the thickness in $\mu$m of the colloid composite layer structure in dry state, $S_2$ is the thickness in $\mu$m of the same composition in wet state after flowing with activator liquid over the composite layer and simultaneously plotting the change in swell until no further change in swell occurs.

- 13 -

## CLAIMS

1. A process for preparing a photographic resist image which comprises the steps of :

(1) exposing to a subject a photographic material comprising in the following order :

    (i)     a support optionally provided with (a) subbing layer(s) for improving the adherence to a hydrophilic colloid layer,

    (ii     a transparent or translucent substantially non-hardened hydrophilic colloid layer essentially containing gelatin as binder and incorporating a hardening developing agent,

    (iii) a substantially non-hardened hydrophilic colloid layer essentially containing gelatin as binder and incorporating colouring substances,

    (iv)   a substantially non-hardened gelatin silver halide emulsion layer, and

    (v)    a transparent substantially non-hardened gelatin protective top layer, and

(2) contacting the exposed material with an alkaline aqueous liquid to activate the development of the developable silver halide forming image-wise oxidized developing agent acting as tanning agent for gelatin,

(3) removing the substantially unhardened portions of the layers (ii) to (v) by wash-off,

characterized in that said alkaline aqueous liquid contains at least 110 g of potassium carbonate per liter.

2. Process according to claim 1, characterized in that the alkaline aqueous liquid contains the potassium carbonate in a concentration in the range of 110 to 150 g per liter.

3. Process according to claim 1 or 2, characterized in that layer (iii) has a thickness in the range of 0.5 um to 10 um and contains from 0.1 to 5 g of gelatin per sq.m.

4. Process according to any of claims 1 to 3, characterized in that the gelatin coverage of the top layer (v) is in the range of 0.5 to 1.5 g per $m^2$.

5. Process according to any of claims 1 to 4, characterized in that the silver halide emulsion layer (iv) has a silver halide coverage equivalent with 0.3 to 3.5 g of silver nitrate per $m^2$, the gelatin to

GV 1345 silver nitrate weight ratio being in the range of 0.5 to 3.0.

6. Process according to any of claims 1 to 5, characterized in that the developing agent is hydroquinone.

7. Process according to any of claims 1 to 6, characterized in that an auxiliary developing agent is present in the top layer (v).

8. Process according to claim 7, characterized in that the auxiliary developing agent is a 3-pyrazolidinone developing agent being present in an amount of 10 to 200 mg per $m^2$.

9. Process according to any of claims 1 to 8, characterized in that the alkaline aqueous liquid contains potassium hydroxide in an amount lower than 30 g per liter.

10. Process according to any of claims 1 to 9, characterized in that the alkaline aqueous liquid contains a substance yielding sulphite ions.

11. Process according to claim 10, characterized in that the sulphite ions are provided by sodium sulphite being present in amount of 0.5 to 5 g/l.

**European Patent Office**

**EUROPEAN SEARCH REPORT**

Application number

EP 84 20 1672

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X,Y | EP-A-0 105 109 (3M) <br> * Page 3, line 14 - page 4, line 24; page 10, line 23 - page 11, line 12; example 1 * | 1-11 | G 03 F 7/06 <br> G 03 C 5/36 <br> G 03 C 5/26 // <br> G 03 F 3/10 <br> G 03 F 1/00 |
| Y | US-A-4 456 676 (J.M. CISKOWSKI) <br> * Example 1 * | 1,2 | |
| Y | US-A-4 299 909 (E. IMATOMI) <br> * Column 17, lines 5-13; claims * | 1,9-11 | |
| Y,X | EP-A-0 104 351 (3M) <br> * Page 6, line 1 - page 7, line 1; page 8, line 10 - page 9, line 22; example 1; claims * | 1-11 | |

| TECHNICAL FIELDS SEARCHED (Int. Cl.4) |
|---|
| G 03 F 7/00 <br> G 03 C 5/00 <br> G 03 F 3/00 <br> G 03 F 1/00 <br> G 03 C 1/00 |

The present search report has been drawn up for all claims

| Place of search | Date of completion of the search | Examiner |
|---|---|---|
| THE HAGUE | 05-07-1985 | PHILOSOPH L.P. |